# EUROPÄISCHE PATENTSCHRIFT

(11) **EP 1 586 226 B1**
(45) Veröffentlichungstag und Bekanntmachung des Hinweises auf die Patenterteilung: **22.11.2006**
(21) Anmeldenummer: 04703151.3
(22) Anmeldetag: 19.01.2004
(51) Int. Cl.: H05K 13/04

(54) **MEHRFACH-BESTÜCKKOPF**
MULTIPLE INSERTION HEAD
TETE D'IMPLANTATION DE COMPOSANTS MULTIPLE

(30) Priorität: 24.01.2003 DE 10302802
(43) Veröffentlichungstag der Anmeldung: 19.10.2005
(73) Patentinhaber: SIEMENS AKTIENGESELLSCHAFT, 80333 München (DE)
(72) Erfinder: JONKE, Gerhard, 82205 Gilching (DE); PITTSCHELLIS, Reinhard, 73779 Deizisau (DE); SCHMID, Rudolf, 82223 Eichenau (DE); STADLER, Uwe, 82140 Olching (DE); TRIGIANI, Michele, 81373 München (DE)
(86) Internationale Anmeldenummer: PCT/EP2004/000352
(87) Internationale Veröffentlichungsnummer: WO 2004/066700

(56) Entgegenhaltungen:
- EP-A- 1 032 251
- US-A- 5 313 401

## Beschreibung

Die Erfindung betrifft einen Mehrfach-Bestückkopf zum Bestücken von Bauelementen auf Substrate.

Derartige Bestückköpfe finden insbesondere Verwendung in Vorrichtungen zum Bestücken von Leiterplatten mit Bauelementen, die mindestens einen drehbaren Mehrfach-Bestückkopf mit mehreren Aufnahmewerkzeugen für Bauelemente aufweisen. Der wesentliche Einsatz der Vorrichtungen zum Bestücken ist bei der SMD-Technik angesiedelt.

Im Bereich der Bestückautomaten für elektrische Bauelemente ist das sogenannte "Pick-and-Place"-Verfahren weit verbreitet. Dieses Verfahren besagt, dass Bauelemente einzeln aufgenommen, zentriert und positioniert und auf die Leiterplatten bzw. Substrate einzeln aufgesetzt werden. Ein derartiger Vorgang wird für jedes einzelne Bauelement durchgeführt.

Mehrfach-Bestückköpfe für das "Pick-and-Place"-Verfahren sind beispielsweise aus der DE 19654172 sowie aus der EP 315799 bekannt. Beide oben genannten Dokumente offenbaren jeweils mindestens einen drehbaren Mehrfach-Bestückkopf mit mehreren Aufnahmewerkzeugen für Bauelemente. Um die nach dem "Pick-and-Place"-Verfahren erforderlichen Vorgänge wie Aufnehmen, Zentrieren und Absetzen durchführen zu können, sind die jeweiligen Aufnahmewerkzeuge der bekannten Mehrfach-Bestückköpfe jeweils in und entgegen einer Aufsetzrichtung bewegbar angeordnet sowie um eine Drehachse drehbar gelagert.

Für eine exakte Positionierung der zu bestückenden elektrischen Bauelemente ist eine genaue Winkelausrichtung der Bauelemente an den Aufnahmewerkzeugen erforderlich, da anderenfalls Fehlbestückungen erfolgen.

Hierzu wird nach dem Aufnehmen des Bauelements an dem Aufnahmewerkzeug dieses mittels einer externen Vorrichtung gedreht, bis sich das zu bestückende Bauelement in der vorgegebenen Winkelstellung an dem Aufnahmewerkzeug befindet. Dazu ist bei den bekannten Mehrfach-Bestückköpfen eine Drehvorrichtung erforderlich, welche von außen an die Aufnahmewerkzeuge ankoppelt und nach dem Drehen wieder abkoppelt.

Ferner wird bei den bekannten Mehrfach-Bestückköpfen vielfach Vakuum verwendet, um die zu bestückenden Bauelemente an den Aufnahmewerkzeugen zu halten. Das hierfür erforderliche Vakuum wird außerhalb des Bestückkopfs erzeugt und über Unterdruckleitungen bis an die Spitzen der Aufnahmewerkzeuge geleitet. Hierfür ist eine hohe Vakuumleistung erforderlich, da die Leitungen sehr lang sind.

Der Erfindung liegt daher die Aufgabe zugrunde, einen Mehrfach-Bestückkopf zu schaffen, welcher ein hochgenaues und schnelles Bestücken von elektrischen Bauelementen auf Substrate ermöglicht. Diese Aufgabe wird erfindungsgemäß durch einen Mehrfach-Bestückkopf mit den Merkmalen nach Anspruch 1 gelöst. Bevorzugte Ausgestaltungen der Erfindung sind in den abhängigen Ansprüchen beansprucht.

Erfindungsgemäß wird ein Mehrfach-Bestückkopf zum Bestücken von Bauelementen auf Substrate geschaffen, welcher einen Träger aufweist, der um eine Drehachse drehbar angeordnet ist, und der eine Mehrzahl von in einer zu einer Drehachse winkeligen Aufsetzrichtung bewegbaren Aufnahmewerkzeugen aufweist, die an dem Träger angeordnet sind und von welchen die Bauelemente aufgenommen werden können. Jedes Aufnahmewerkzeug ist mit einen oder mehreren aktiven Antrieben und/oder Sensoren versehen.

Hierdurch wird ermöglicht, unabhängig von externen Aktoren zu bestücken, wodurch die Bestückgenauigkeit wesentlich verbessert wird, da kein An- bzw. Abkoppeln der externen Aktoren erforderlich ist.

Insbesondere ist jedes Aufnahmewerkzeug mit einem eigenen Drehantrieb als aktivem Antrieb versehen, von welchem aufgenommene Bauelemente jeweils um eine zur Drehachse des Trägers winkelig angeordnete Werkzeugachse gedreht werden können. Der Drehantrieb kann beispielsweise in einer Baueinheit mit einem Sensor zusammen vorgesehen sein, von welchem die Drehbewegung des Drehantriebs und damit die Drehbewegung des zu bestückenden Bauelements erfassbar ist. Hierdurch ist ein geschlossener Regelkreis für das Drehen des zu bestückenden Bauelements geschaffen. Da keine An- bzw. Abkoppelvorgänge erforderlich sind, treten auch keine hiermit verbundenen Winkelfehler der Drehbewegung des zu bestückenden Bauelements auf. Ferner kann die Zeit für das An- bzw. Abkoppeln eines externen Aktors eingespart werden.

Jedes Aufnahmewerkzeug kann erfindungsgemäß einen Vakuumerzeuger als aktiven Antrieb für das Halten der Bauelemente an den Aufnahmewerkzeugen aufweisen, welcher insbesondere als Venturirohr ausgebildet ist. Hierbei ist der Träger mit einer Hohlwelle versehen, die koaxial zur Drehachse verläuft und an welcher die Aufnahmewerkzeuge angebracht sind. Durch die Hohlwelle des Trägers hindurch können die Venturirohre mit Druckluft beaufschlagt werden, so dass das zum Aufnehmen und Halten der zu bestückenden Bauelemente an den Aufnahmewerkzeugen erforderliche Vakuum erzeugt werden kann. Dies bietet den Vorteil, dass nur sehr kurze Vakuumleitungen zwischen dem Vakuumerzeuger und dem Aufnahmewerkzeug erforderlich sind, wodurch Vakuumverluste vermieden werden und ein konstantes Vakuumniveau an den jeweiligen Aufnahmewerkzeugen ermöglicht wird. Außerdem bietet die jeweils separate Vakuumversorgung der jeweiligen Aufnahmewerkzeuge den Vorteil, dass bei Abfallen eines Bauelements von einem Aufnahmewerkzeug sich der Vakuumpegel an den übrigen Aufnahmewerkzeugen nicht verändert.

Darüber hinaus kann durch die einheitliche Druckluftzufuhr zu allen Aufnahmewerkzeugen eine Anpassung an den Umgebungsluftdruck durchgeführt werden. Hierzu ist die Druckluftversorgung der Vakuumerzeuger der Aufnahmewerkzeuge mit einem Proportionalventil versehen, von welchem abhängig vom Umgebungsdruck der Versorgungsdruck einstellbar ist. Je höher der Umgebungsluftdruck ist, desto geringer wird der Versorgungsluftdruck gewählt. Dies hat zur Folge, dass vor allem auf Meereshöhe der Luftverbrauch stark absinkt. Darüber hinaus wird die Bestücksicherheit durch gleichbleibenden Luftdruck und damit gleichbleibendes Vakuumniveau an den Aufnahmewerkzeugen verbessert.

Darüber hinaus kann der Mehrfach-Bestückkopf nach der Erfindung eine Blasluft-Vakuum-Vorrichtung aufweisen, welche es ermöglicht, in einer Aufnahme-Bestückposition des Trägers befindliche Aufnahmewerkzeuge beim Aufnehmen von Bauelementen mit Vakuum zu versorgen und beim Bestücken von Bauelementen mit einem Blasluftimpuls zu versorgen. Hierdurch ist einerseits das Anlegen eines zum Aufnehmen von Bauelementen geeigneten Vakuumpegels an die Aufnahmewerkzeuge möglich und andererseits ein beschleunigtes Bestücken der zu bestückenden Bauelemente mittels eines Blasluftimpulses möglich.

Die Blasluft-Vakuum-Vorrichtung kann beispielsweise ein Venturirohr aufweisen, dessen abluftseitiger Ausgang mittels eines Ventils verschließbar ist. Bei kurzzeitigem Verschließen der Abluftseite des Venturirohrs erzeugt dieses kein Vakuum, sondern es wird ein Blasluftimpuls ausgegeben. Ferner kann hierbei ein Drucksensor vorgesehen sein, welcher ein geregeltes Schließen der Abluftseite des Venturirohrs ermöglicht, so dass ein beliebiger Druck-Pegel eingestellt werden kann.

Die Aufnahmewerkzeuge weisen beispielsweise eine als Hohlwelle ausgebildete Werkzeugwelle auf, welche koaxial zu der Werkzeugachse verläuft. Durch diese Hohlwelle hindurch kann das mittels der an dem Aufnahmewerkzeug vorgesehenen Vakuumerzeuger und/oder mittels der Blasluft-Vakuum-Vorrichtung an das Aufnahmewerkzeug angelegte Vakuum bzw. Blasluftimpuls an den distalen Endbereich der Werkzeugwellen geleitet werden. Dort sind beispielsweise Vakuumpipetten vorgesehen, an welchen die zu bestückenden Bauelemente angesaugt sind.

Da der Träger drehbar an dem Mehrfach-Bestückkopf angebracht ist, ist eine rotationssymmetrische Energie- und Datenübertragungsvorrichtung erforderlich, von welcher die aktiven Antriebe und/oder Sensoren mit Energie versorgt werden können sowie von welcher die Daten der Sensoren übertragen werden können. Hierbei ist ein erster Übertragerteil fest an dem Gehäuse des Mehrfach-Bestückkopfs angebracht und in zweiter Übertragerteil ist fest an dem drehbaren Träger angebracht. Beispielsweise ist die Energie- und Datenübertragungsvorrichtung mit mindestens einem Schleifring versehen, über welchen Energie sowie Daten übertragen werden können. Es ist jedoch auch möglich, jeweils ein Paar elektrischer z.B. induktiver Übertrager und ein Paar kapazitiver Übertrager vorzusehen, welche jeweils rotationssymmetrisch um die Drehachse des Mehrfach-Bestückkopfs angeordnet sind und von welchen die Energie und die Daten kontaktlos übertragen werden können. Dies bietet den Vorteil einer verschleißfreien Energie- und Datenübertragung.

Der kapazitive Übertrager ist hierbei an dem ersten Übertragerteil und an dem zweiten Übertragerteil insbesondere jeweils als plattenförmige Antenne ausgebildet. Der elektromagnetische Übertrager kann an dem ersten Übertragerteil einen ringförmig ausgebildeten magnetisch leitfähigen Körper mit U-förmigem, in Richtung zu dem Träger hin offenen Querschnitt aufweisen sowie an dem zweiten Übertragerteil einen ringförmig ausgebildeten magnetisch leitenden Körper mit im Wesentlichen rechteckigen Querschnitt aufweisen, der derart in der Öffnung des ersten Übertagerteils angeordnet ist, dass die Richtung des zur Energieübertragung genutzten Magnetfeldes zur Richtung des zur Datenübertragung genutzten elektrischen Feldes im Wesentlichen senkrecht steht. Dies bietet den Vorteil einer kompakt aufgebauten kontaktlosen Energie- und Datenübertragung, bei der im Wesentlichen kein Störfeld auftritt.

An dem Gehäuse des Mehrfach-Bestückkopfs sowie an dem Träger können jeweils Schliffscheiben derart vorgesehen sein, dass eine rotationssymmetrische Übertragung von Druckluft und Vakuum an alle Positionen der Aufnahmewerkzeuge bzw. an ausgewählte Positionen der Aufnahmewerkzeuge möglich ist. Eine ausgewählte Position der Aufnahmewerkzeuge ist beispielsweise die Aufnahme-Bestückposition.

An dem Träger kann mindestens eine Steuervorrichtung vorgesehen sein, von welcher die aktiven Antriebe bzw. Sensoren gesteuert werden können. Hierzu kann ein Signalprozessor jeweils für einen oder mehrere der aktiven Antriebe bzw. Sensoren verwendet werden.

Hierdurch ist eine dezentrale Verarbeitung von Steuerdaten bzw. Sensordaten möglich, wodurch die über die rotationssymmetrische Energie- und Datenübertragungsvorrichtung zu übertragende Datenmenge reduziert wird. Somit kann die Geschwindigkeit des Mehrfach-Bestückkopfs gesteigert werden.

Um ein Bewegen der Aufnahmewerkzeuge in der Aufsetzrichtung zu ermöglichen, ist als Linearantrieb beispielsweise ein Linearmotor vorgesehen, mit welchem jenes Aufnahmewerkzeug in Eingriff ist, welches sich in der Aufnahme-Bestückposition befindet. Somit kann das in der Aufnahme-Bestückposition befindliche Aufnahmewerkzeug mittels des Linearmotors in der Aufsetzrichtung bewegt werden.

Das Verwenden eines Linearmotors zur Bewegung des zu bestückenden Bauelements in der Aufsetzrichtung bietet die Vorteile einer genaueren Positionierung, Reduzierung der bewegten Masse sowie kürzere Verfahrzeiten.

An dem Mehrfach-Bestückkopf kann zusätzlich ein Rückholmittel vorgesehen sein, von welchem der Läufer des Linearmotors mittels Federkraft entgegen der Schwerkraft vorgespannt ist, und wobei im Betrieb des Bestückkopfs diese Vorspannung mittels Luftdruck kompensiert ist. Hierdurch ist sichergestellt, dass bei Ausfall der Energieversorgung der Läufer des Linearmotors nicht unkontrolliert herabgleitet, wodurch beim Verfahren des Mehrfach-Bestückkopfs über der Bestückebene Beschädigungen des Mehrfach-Bestückkopfs vermieden werden können.

Beispielsweise ist die Drehachse des Mehrfach-Bestückkopfs zu der Bestückebene geneigt angeordnet, so dass das in der Bestückposition befindliche Aufnahmewerkzeug senkrecht zur Bestückebene angeordnet ist. Durch die kegelförmige Anordnung der Aufnahmewerkzeuge an dem Mehrfachbestückkopf ist es möglich, eine Bauelementekamera derart gegenüberliegend der Bestückposition und dieser zugewandt anzuordnen, dass ein Teilbereich der Optik der Bauelementekamera unterhalb der an dem in der Bestückposition befindlichen Aufnahmewerkzeug aufgenommenen Bauelemente positioniert werden kann. Hierdurch ist es möglich, sowohl die korrekte Lage des aufgenommenen Bauelements an dem Aufnahmewerkzeug, als auch die Höhe des Bauelements zu ermitteln.

Die Erfindung wird unter Bezugnahme auf die Zeichnung näher erläutert. In der Zeichnung zeigen:
Figur 1 eine seitliche Schnittansicht einer bevorzugten Ausführungsform des erfindungsgemäßen Mehrfach-Bestückkopfs, und
Figur 2 eine teilweise perspektivische Ansicht der bevorzugten Ausführungsform des erfindungsgemäßen Mehrfach-Bestückkopfs.

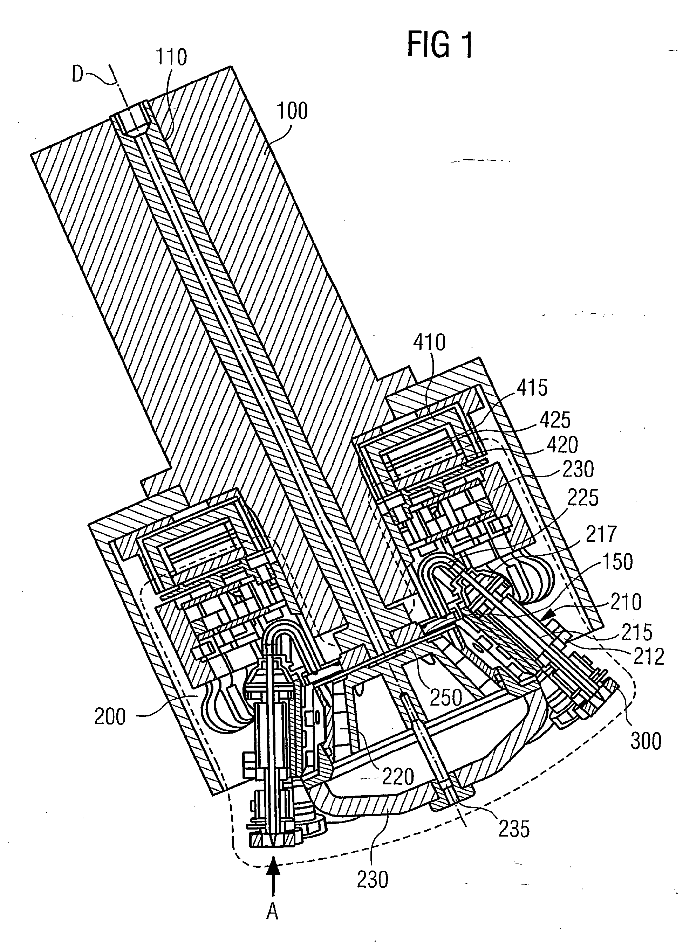

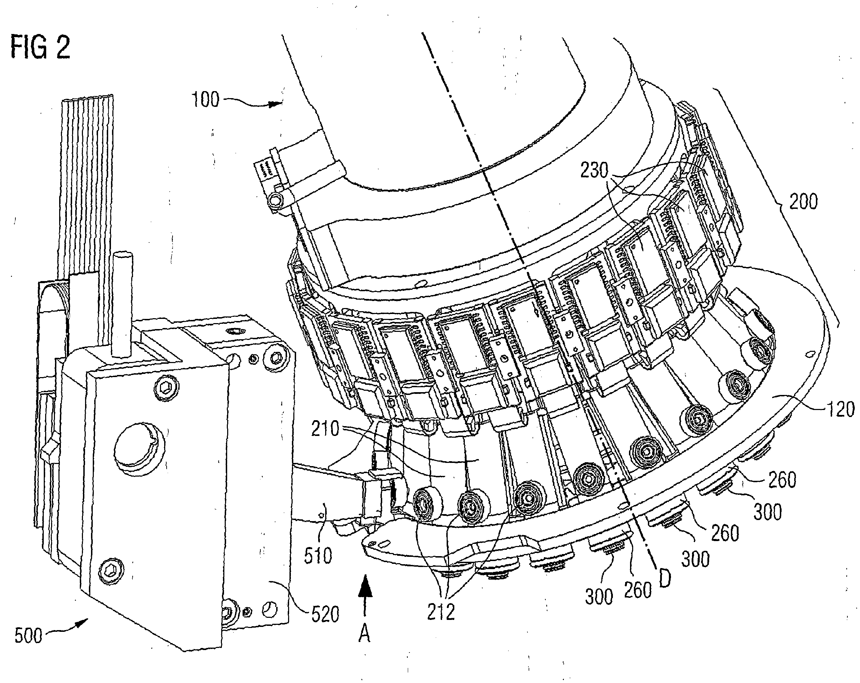

Wie aus den Figuren 1 und 2 ersichtlich, weist eine bevorzugte Ausführungsform des erfindungsgemäßen Mehrfach-Bestückkopfs einen Drehantrieb 100 mit einer Antriebswelle 110 auf, welche entlang der Drehachse D des Trägers 200 nach der bevorzugten Ausführungsform verläuft. Am Anschlussbereich des Trägers 200 an der Antriebswelle 110 ist mit mindestens ein Paar von Schliffscheiben 150, 250 vorgesehen. Die Schliffscheibe 150 ist hierbei mit dem Gehäuse des Drehantriebs 100 verbunden. Die Schliffscheibe 250 ist an der dem Drehantrieb 100 zugewandten Seite des Trägers 200 angebracht, um über die Antriebswelle 110 zugeführte Druckluft an eines oder mehrere der Aufnahmewerkzeuge 210 weiterleiten zu können. Um durch die Antriebswelle 110 hindurch Druckluft an die Aufnahmewerkzeuge 210 weiterleiten zu können, ist die Antriebswelle 110 als Hohlwelle ausgebildet, wie aus der Figur 1 ersichtlich.

Darüber hinaus sind an der Oberseite der trägerseitigen Schliffscheibe 250 Öffnungen angebracht, durch welche hindurch über Druckluft in dem Träger 200 für jedes Aufnahmewerkzeug gesondert geleitet werden kann, um Vakuum für das jeweilige Aufnahmewerkzeug 210 mittels dessen Vakuumerzeugers erzeugen zu können. Hierzu weist der Träger für jedes Aufnahmewerkzeug 210 eine Venturidüse 220 auf, welche über die Antriebswelle 110 und die Schliffscheiben 150 und 250 mit Druckluft versorgt wird, um Vakuum zu erzeugen und dieses an die jeweiligen Werkzeugwellen 215 weiterleiten zu können.

An dem von dem Drehantrieb 100 entfernten Endbereich des Trägers 200 ist eine Kappe 235 vorgesehen, von welcher die Abluft der Mehrzahl von Venturidüsen 220 umgeleitet und zum Kühlen an den Aufnahmewerkzeugen 210 vorbeigeführt wird. Hierdurch kann auf eine gesonderte Kühleinrichtung zum Kühlen der Drehantriebe in den Aufnahmewerkzeugen 210 verzichtet werden.

Der Träger ist im Wesentlichen rotationssymmetrisch aufgebaut und weist einen kegelstumpfförmigen Körper auf, wobei an der Umfangsfläche des Kegelstumpfs die Aufnahmewerkzeuge 210 gleichmäßig verteilt angebracht sind. Mittels jeweils einer Linearführung ist jedes Aufnahmewerkzeug 210 in der Richtung tangential zu der Umfangsfläche des Trägers 210 in der Aufsetzrichtung linear bewegbar angeordnet. Die Aufnahmewerkzeuge 210 sind jeweils mit einem Mitnehmerelement 212 versehen, welches jeweils an einem konzentrisch zu der Drehachse D angeordneten Laufring 120 abgestützt ist.

Der Laufring 120 ist an einem Gehäuse des Mehrfach-Bestückkopfs fest angebracht, so dass er zur zirkularen Führung der Aufnahmewerkzeuge 210 dienen kann. An einer Aufnahme-Bestückposition A ist der Laufring 120 für die Breite des Mitnehmerelements 212 unterbrochen. Hierdurch kann ein an dem Gehäuse des Mehrfachbestückkopfs vorgesehener Linearantrieb 500 mit einem Mitnehmer 510, welcher an seinem Läufer 520 fest angebracht ist, an dem Mitnehmerelement 212 eingreifen und das entsprechende Aufnahmewerkzeug, das, sich in der Aufnahme-Bestückposition (A) befindet, linear in der Aufsetzrichtung bewegen, um Bauelemente 300 aus Zuführeinrichtungen zu entnehmen und /oder Bauelemente 300 auf Substraten zu positionieren. Die Bauelemente 300 sind beispielsweise an Vakuumpipetten 260 mittels Vakuum angesaugt, welche an den Aufnahmewerkzeugen 210 jeweils an deren distalen Endbereichen befestigt sind.

Jedes Aufnahmewerkzeug 210 weist eine als Hohlwelle ausgebildete Werkzeugwelle 215 auf, an welcher die Vakuumpipette 260 angebracht ist. Hierbei ist die Vakuumpipette 260 jeweils in Richtung der Werkzeugachse der Werkzeugwelle 215 federnd und vakuumdicht an dem Aufnahmewerkzeug 210 angeordnet. Darüber hinaus weist jedes Aufnahmewerkzeug einen eigenen elektrischen Drehantrieb 228, der mit der Werkzeugwelle 215 verbunden ist, sowie einen Winkelsensor 217 für den Drehantrieb 228 auf. Der Winkelsensor 217 bildet somit zusammen mit dem Drehantrieb 228 und einer Auswerteelektronik 230, welche ebenfalls an dem Träger 200 angebracht ist, einen geschlossenen Regelkreis zur Erfassung der Drehbewegungen der Vakuumpipetten 260 und somit der Bauelemente 300.

Um zwischen dem Gehäuse des Mehrfach-Bestückkopfs nach der bevorzugten Ausführungsform der Erfindung und dem Träger 200 Energie und Daten zu übertragen, kann einerseits einer oder eine Mehrzahl von Schleifringen zwischen dem Drehantrieb 100 und dem Träger 200 vorgesehen sein (nicht gezeigt).

Es ist jedoch auch möglich, eine kontaktlose Energie- und Datenübertragung zwischen dem Drehantrieb 100 und dem Träger 200 vorzusehen. Hierzu ist, wie aus Figur 1 ersichtlich, an dem Drehantrieb 100 ein erster Übertragerteil mit einem ringförmigen Körper aus magnetisch leitfähigem Material 410 mit U-förmigem Querschnitt angeordnet, wobei der durch den U-förmigen Querschnitt entstehende Hohlraum zu dem Träger 200 hin offen ausgebildet ist. Außerdem ist eine mit dem ringförmigem Körper 410 in elektromagnetischer Wechselwirkung stehende Spule (nicht gezeigt) vorgesehen. Darüber hinaus ist an dem Drehantrieb 100 im Bereich des ringförmigen Körpers 410 eine plattenförmige rotationssymmetrische Antenne 415, welche jedenfalls in Ringformat ausgebildet ist, vorgesehen.

An dem Träger 200 ist eine der plattenförmigen Antenne 415 des Antriebs 100 entsprechende Antenne 425 vorgesehen. Darüber hinaus ist an dem Träger, an dem dem Drehantrieb 100 zugewandten Bereich ein zweiter Übertragerteil mit einem ringförmigen magnetisch leitfähigen Körper 420 mit rechteckigem Querschnitt vorgesehen, welcher in dem durch den U-förmigen Querschnitt des ringförmigen Körpers 410 hervorgerufenen Hohlraum zusammen mit der plattenförmigen Antenne 420 relativ zu dem Drehantrieb 100 drehbar und fest an dem Träger 200 angebracht ist. Darüber hinaus ist an dem Träger 200 eine mit dem ringförmigen Körper 420 elektromagnetisch wirkverbundene Spule (nicht gezeigt) vorgesehen.

Somit ist es unabhängig von der Drehung des Trägers 200 relativ zu dem Drehantrieb 100 jederzeit möglich, über die Spulen und die ringförmigen Körper 410 bzw. 420 Energie von dem Drehantrieb 100 zu dem Träger 200 zu übertragen. Darüber hinaus können ebenfalls unabhängig von der Rotation des Trägers 200 relativ zu dem Drehantrieb 100 Daten über die beiden Antennen 415 bzw. 425 zwischen dem Drehantrieb 100 und dem Träger 200 in beiden Richtungen ausgetauscht werden.

Die übertragenen Daten und Energie werden zum Ansteuern der Drehantriebe der Aufnahmewerkzeuge 210 in Verbindung mit den Drehantrieben der Aufnahmewerkzeuge und den Drehsensoren 217 der Aufnahmewerkzeuge 210 verwendet. Hierzu ist beispielsweise für jedes Aufnahmewerkzeug 210 eine Steuereinrichtung 230 vorgesehen, welche insbesondere einen digitalen Signalprozessor aufweist. Es ist jedoch auch möglich, an dem Träger 200 lediglich eine oder eine geringe Anzahl von Steuervorrichtungen 230 vorzusehen und jeweils eine Mehrzahl von Aufnahmewerkzeugen 210 oder alle Aufnahmewerkzeuge 210 mittels eines einzigen digitalen Signalprozessors zu steuern.

In der Aufnahme-Bestückposition A, in welcher das dort befindliche Aufnahmewerkzeug 210 mittels des Mitnehmerelements 212 durch den Linearantrieb 500 in der Aufsetzrichtung bewegt werden kann, ist auch durch eine in dieser Stellung für das jeweilige Aufnahmewerkzeug 210 an dem Träger 200 durchlässige Schliffscheibe (nicht gezeigt), welche zwischen dem Drehantrieb 100 und dem Träger 200 angeordnet ist, zusätzlich das Zuführen von Vakuum bzw. Druckluft über die Vakuumleitung 225 möglich.

Hierzu wird ein zusätzlicher Vakuumerzeuger verwendet (nicht gezeigt), welcher in der Aufnahme-Bestückposition über die zusätzliche Schliffscheibe mit der Vakuumleitung 225 jenes Aufnahmewerkzeugs 210 verbunden ist, welches sich in der Aufnahme-Bestückposition befindet. Dieser zusätzliche Vakuumerzeuger kann beispielsweise ein Venturirohr sein, welches abluftseitig mit einem Proportionalventil verschlossen werden kann. Bei unterschiedlich geöffnetem Ventil kann ein beliebiges Vakuumniveau an dem Aufnahmewerkzeug 210 realisiert werden.

Hierdurch ist es möglich, Bauelemente 300 aus Zuführeinrichtungen (nicht gezeigt) sicher abzuholen. Hierzu wird der Mehrfach-Bestückkopf mit der Vakuum-Pipette 260 des in der Aufnahme-Bestückposition befindlichen Aufnahmewerkzeugs 210 über das zu entnehmende Bauelement 300 in der Zuführeinrichtung verfahren und anschließend mittels des Linearantriebs auf das Bauelement 300 abgesenkt. Durch Einschalten des zusätzlichen Vakuums ist ein sicheres Entnehmen des Bauelements möglich.

Beim Absetzen der aufgenommenen Bauelemente 300 ist durch den zusätzlichen Vakuumerzeuger in der Aufnahme-Bestückposition ermöglicht, einen Druckluftimpuls an das in der Aufnahme-Bestückposition befindliche Aufnahmewerkzeug 210 zu senden, von welchem das angelegte Vakuum überblasen wird, so dass das zu bestückende Bauelement 300 von dem Aufnahmewerkzeug 210 weg auf ein zu bestückendes Substrat (nicht gezeigt) gedrückt wird.

## Patentansprüche

1. Mehrfach-Bestückkopf zum Bestücken von Bauelementen auf Substrate, mit
- einem Träger (200), der um eine Drehachse drehbar angeordnet ist, und
- einer Mehrzahl von in einer zu der Drehachse (D) winkligen Aufsetzrichtung bewegbaren Aufnahmewerkzeugen (210), welche an dem Träger (200) angeordnet sind und von welchen die Bauelemente (300) aufgenommen werden können,
wobei jedes Aufnahmewerkzeug(210) mit einem oder mehreren aktiven Antrieben (220, 228) und/oder Sensoren (217) versehen ist.

2. Mehrfach-Bestückkopf nach Anspruch 1, wobei jedes Aufnahmewerkzeug (210) einen eigenen Drehantrieb (228) aufweist, von welchem aufgenommene Bauelemente (300) jeweils um eine zur Drehachse (D) des Mehrfach-Bestückkopfs winklig angeordnete Werkzeugachse (215) gedreht werden können.

3. Mehrfach-Bestückkopf nach Anspruch 1, wobei jedes Aufnahmewerkzeug (210) einen Vakuumerzeuger (220) aufweist.

4. Mehrfach-Bestückkopf nach Anspruch 3, wobei die Vakuumerzeuger (220) Venturirohre sind und der Träger (200) eine Hohlwelle (110) koaxial zu der Drehachse (D) aufweist, an welcher die Aufnahmewerkzeuge (210) angebracht sind, und durch welche Hohlwelle (110) hindurch die Venturirohre mit Druckluft beaufschlagt werden können.

5. Mehrfach-Bestückkopf nach einem der Ansprüche 3 oder 4, wobei die Venturirohre mit einem Regler zur Druckregelung verbunden sind.

6. Mehrfach-Bestückkopf nach einem der Ansprüche 1 bis 5, wobei eine Blasluft-Vakuum-Vorrichtung vorgesehen ist, welche in einer Aufnahme-Bestückposition (A) eines der Aufnahmewerkzeuge (210), in welcher Bauelemente von dem in der Aufnahme-Bestückposition (A) befindlichen Aufnahmewerkzeug (210) aufgenommen bzw. bestückt werden können, mit dem jeweils in der Aufnahme-Bestückposition (A) befindlichen Aufnahmewerkzeug (210) verbunden ist und von welcher zusätzlich Vakuum an die Aufnahmewerkzeuge (210)zum Aufnehmen der Bauelemente bzw. zusätzlich ein Blasluftimpuls während des Bestückens der Bauelemente an das in der Aufnahme-Bestückposition (A) befindliche Aufnahmewerkzeug (210) angelegt bzw. abgegeben werden kann.

7. Mehrfach-Bestückkopf nach Anspruch 1 bis 6, wobei die Aufnahmewerkzeuge (210) jeweils eine als Hohlwelle ausgebildete Werkzeugwelle (215) koaxial zu der Werkzeugachse aufweisen, und wobei jedes Aufnahmewerkzeug (210) einen Drehsensor (217) aufweist, von welchem die Winkelstellung der Werkzeugwelle (215) erfasst werden kann.

8. Mehrfach-Bestückkopf nach Anspruch 7, wobei die Werkzeugwellen (215) jeweils an ihrem distalen Endbereich mit Vakuumpipetten (260) versehen sind.

9. Mehrfach-Bestückkopf nach einem der Ansprüche 1 bis 8, wobei zwischen dem Träger (200) und einem Gehäuse (100) des Mehrfach-Bestückkopfs eine rotationssymmetrische Energie- und Datenübertragungs-Vorrichtung angeordnet ist, von welcher die aktiven Antriebe (220, 228) und/oder Sensoren (217) mit Energie versorgt werden können und von welcher die Daten der Sensoren und Daten an die Sensoren übertragen werden können, wobei ein erster Übertragerteil fest an dem Gehäuse (100) des Mehrfach-Bestückkopfs angebracht ist und ein zweiter Übertragerteil fest an dem drehbaren Träger (200) angebracht ist.

10. Mehrfach-Bestückkopf nach Anspruch 9, wobei die Energie- und Datenübertragungsvorrichtung mindestens einen Schleifring aufweist.

11. Mehrfach-Bestückkopf nach Anspruch 9, wobei die Energie- und Datenübertragungsvorrichtung jeweils ein Paar elektromagnetischer Übertrager (410, 420) und ein Paar kapazitiver Übertrager (415, 425) aufweist, welche jeweils rotationssymmetrisch um die Drehachse des Mehrfach-Bestückkopfs angeordnet sind und von welchen die Energie und die Daten kontaktlos übertragen werden können.

12. Mehrfach-Bestückkopf nach Anspruch 11, wobei der kapazitive Übertrager (415, 425) an dem ersten Übertragerteil und an dem zweiten Übertragerteil jeweils als plattenförmige Antenne ausgebildet ist und wobei der elektromagnetische Übertrager an dem ersten Übertragerteil einen ringförmig ausgebildeten magnetisch leitenden Körper (410) mit u-förmigen, in Richtung zu dem Träg.er-hin offenen Querschnitt aufweist und an dem zweiten Übertragerteil einen ringförmig ausgebildeten magnetisch leitenden Körper (420) mit im Wesentlichen rechteckigem Querschnitt aufweist, welcher derart in der Öffnung des ersten Übertragerteils angeordnet ist, dass die Richtung des zur Energieübertragung genutzten Magnetfeldes zur Richtung des zur Datenübertragung genutzten elektrischen Feldes im Wesentlichen senkrecht steht.

13. Mehrfach-Bestückkopf nach einem der Ansprüche 9 bis 12, wobei an dem Gehäuse (100) und an dem Träger (200) jeweils mindestens eine Schliffscheibe (150, 250) derart vorgesehen ist, dass die Schliffscheiben (150, 250) unmittelbar aneinander angeordnet sind, so dass Druckluft und Vakuum von externen Vakuumerzeugern an die aktiven Antriebe (220) des Trägers angelegt werden kann.

14. Mehrfach-Bestückkopf nach einem der Ansprüche 1 bis 13, wobei der Träger (200) mindestens eine Steuervorrichtung (230) zum Steuern und/oder Regeln der aktiven Antriebe (220, 228) bzw. Sensoren (217) aufweist.

15. Mehrfach-Bestückkopf nach Anspruch 14, wobei die Steuervorrichtung (230) mindestens einen digitalen Signalprozessor aufweist, von welchem jeweils ein oder mehrere der aktiven Antriebe (220, 228) bzw. Sensoren (217) steuerbar sind.

16. Mehrfach-Bestückkopf nach einem der vorangegangenen Ansprüche, wobei zusätzlich ein Linearmotor (500) vorgesehen ist, von welchem ein in der Aufnahme-Bestückposition (A) befindliches Aufnahmewerkzeug (210) in der Aufsetzrichtung bewegbar ist, sofern der Linearmotor (500) mit dem Aufnahmewerkzeug in Eingriff ist.

17. Mehrfach-Bestückkopf nach Anspruch 16, wobei an jedem Aufnahmewerkzeug ein Mitnehmerelement (212) vorgesehen ist, welches mit einem Mitnehmer (510) des Läufers (520) des Linearmotors (500) in Eingriff gebracht werden kann.

18. Mehrfach-Bestückkopf nach einem der Ansprüche 16 oder 17, zusätzlich mit einem mit dem Linearmotor (500) zusammenwirkenden Rückholmittel, von welchem der Läufer (520) des Linearmotors mittels Federkraft entgegen der Schwerkraft vorgespannt ist, wobei im Betrieb des Bestückkopfs diese Vorspannung mittels Luftdruck kompensiert ist.

## Claims

1. Multiple insertion head for mounting components onto substrates, with
- a carrier (200) which is arranged such that it can rotate about a rotational axis, and
- a plurality of receiving tools (210) that are arranged such that they can be moved in a mounting direction at an angle to the rotational axis (D); said receiving tools being arranged on the carrier (200) and used to receive the components (300),
with each receiving tool (210) being provided with one or a plurality of active drives (220, 228) and/or sensors (217).

2. Multiple insertion head according to claim 1, with each receiving tool (210) having its own rotary drive (228) by means of which received components (300) can in each case be rotated about a tool axis (215) arranged at an angle to the rotational axis (D) of the multiple insertion head.

3. Multiple insertion head according to claim 1, with each receiving tool (210) having a vacuum generator (220).

4. Multiple insertion head according to claim 3, with the vacuum generators (220) being Venturi tubes and the carrier (200) has a hollow shaft (110) running coaxially to the rotational axis (D) to which the receiving tools (210) are fitted and compressed air can be conveyed through the hollow shaft (110) of the carrier to the Venturi tubes.

5. Multiple insertion head according to one of the claims 3 or 4, with the Venturi tubes being connected to a regulator to control the pressure.

6. Multiple insertion head according to one of the claims 1 to 5, with a blast air vacuum device being provided which in a receiving mounting position (A) of one of the receiving tools (210), in which components can be received or mounted by means of the receiving tool (210) located in the receiving mounting position (A), with which the receiving tool (210) located in the receiving mounting position (A) is connected in each case and by means of which an additional vacuum can be applied or generated to the receiving tools (210) for receiving the components or in addition a blast air impulse while mounting the components in the receiving tool (210) located in the receiving mounting position (A).

7. Multiple insertion head according to claim 1 to 6, with the receiving tools (210) in each case having a tool shaft (215) embodied as a hollow shaft running coaxially to the tool axis and with each receiving tool (210) having a rotary sensor (217) by means of which the angle position of the tool shaft (215) can be detected.

8. Multiple insertion head according to claim 7, with the tool shafts (215) being provided in each case with vacuum pipettes (260) at their distal end range.

9. Multiple insertion head according to one of the claims 1 to 8, with a rotationally symmetrical energy and data transmission device being arranged between the carrier (200) and a housing (100) of the multiple insertion head, and by means of which the active drives (220, 228) and/or sensors (217) can be supplied with energy and by which the data from the sensors and the data to the sensors can be transmitted with a first transmitter part being permanently fitted to the housing (100) of the multiple insertion head and a second transmitter part being permanently fitted to the carrier (200) in such a way that it can rotate.

10. Multiple insertion head according to claim 9, with the energy and data transmission device having at least one slip ring.

11. Multiple insertion head according to claim 9, with the energy and data transmission device in each case having one pair of electromagnetic transmitters (410, 420) and one pair of capacitive transmitters (415, 425) which are in each case arranged rotationally symmetrical around the rotational axis of the multiple insertion head and by means of which there is non-contact transmission of both the energy and the data.

12. Multiple insertion head according to claim 11, with the capacitive transmitter (415, 425) is in this case embodied as a plate-shaped antenna in the first transmitter part and in the second transmitter part and in which case in the first transmitter part the electromagnetic transmitter can have a circular magnetically conductive body (410) with a u-shaped cross section open in the direction of the carrier, and a circular magnetically conductive body (420) in the second transmitter part with, in essence, a rectangular cross section which is arranged in such a way in the opening of the first transmitter part that the direction of the magnetic field used for the transmission of energy is, in essence, at right angles to the direction of the electrical field used for the transmission of data.

13. Multiple insertion head according to one of the claims 9 to 12, with at least one polished disk (150, 250) being provided on the housing (100) and on the carrier (200) in each case in such a way that the polished disks (150, 250) are arranged immediately next to each other so that the compressed air and a vacuum can be applied from external vacuum generators to the active drives (220) of the carrier.

14. Multiple insertion head according to one of the claims 1 to 13, with the carrier (200) having at least one control device (230) for controlling and/or regulating the active drives (220, 228) or sensors (217).

15. Multiple insertion head according to claim 14, with the control unit (230) having at least one digital signal processor by means of which one or a plurality of the active drives (220, 228) or sensors (217) can be controlled.

16. Multiple insertion head according to one of the preceding claims, with a linear motor (500) also being provided by means of which a receiving tool (210) found in the receiving mounting position (A) can be moved in the mounting direction provided that the linear motor (500) is engaged in the receiving tool.

17. Multiple insertion head according to claim 16, with an engaging element (212) being provided in each receiving tool which can engage in an engaging piece (510) of the runner (520) of the linear motor (500).

18. Multiple insertion head according to one of the claims 16 or 17, with an additional retracting means interacting with the linear motor (500) by means of which the runner (520) of the linear motor is pretensioned by means of a spring tension against the force of gravity and in which this pretensioning is compensated for by compressed air when the insertion head is in operation.

## Revendications

1. Tête de pose multiple pour implanter des composants sur des substrats, comprenant
- un support (200) qui est disposé de manière rotative autour d'un axe de rotation et
- une pluralité d'outils de préhension (210) mobiles dans une direction de pose angulaire par rapport à l'axe de rotation (D), lesquels outils sont disposés sur le support (200) et par lesquels les composants (300) peuvent être pris, chaque outil de préhension (210) étant pourvu d'un ou de plusieurs entraînements actifs (220, 228) et/ou capteurs (217).

2. Tête de pose multiple selon la revendication 1, chaque outil de préhension (210) comportant un propre entraînement rotatif (228) qui fait tourner des composants (300), une fois qu'ils ont été pris, chacun autour d'un axe (215) de l'outil situé angulairement par rapport à l'axe de rotation (D) de la tête de pose multiple.

3. Tête de pose multiple selon la revendication 1, chaque outil de préhension (210) comportant un générateur de vide (220).

4. Tête de pose multiple selon la revendication 3, les générateurs de vide (220) étant des tubes de Venturi et le support (200) comportant un arbre creux (110) coaxial par rapport à l'axe de rotation (D) et à travers lequel arbre creux (110, les tubes de Venturi pouvant être alimentés en air comprimé.

5. Tête de pose multiple selon l'une des revendications 3 ou 4, les tubes de Venturi étant assemblés à un régulateur pour le réglage de la pression.

6. Tête de pose multiple selon l'une des revendications 1 à 5, un dispositif de vide et d'air soufflé étant prévu, lequel, dans une position de préhension et de pose (A) de l'un des outils de préhension (210) dans laquelle l'outil de préhension (210) en position de préhension et de pose (A) peut prendre resp. implanter des composants, est assemblé à l'outil de préhension (210) qui se trouve respectivement dans la position de préhension et de pose (A) et qui peut appliquer additionnellement un vide aux outils de préhension (210) pour la prise des composants resp. délivrer additionnellement une impulsion d'air soufflé pendant l'implantation des composants à l'outil de préhension (210) en position de préhension et de pose (A).

7. Tête de pose multiple selon l'une des revendications 1 à 6, les outils de préhension (210) comportant chacun un arbre d'outil (215) réalisé en tant qu'arbre creux, coaxialement par rapport à l'axe de l'outil, et chaque outil de préhension (210) comportant un capteur rotatif (217) qui peut détecter la position angulaire de l'arbre (215) de l'outil.

8. Tête de pose multiple selon la revendication 7, dans laquelle les arbres (215) des outils sont respectivement pourvus de pipettes à vide (260) dans leur zone terminale distale.

9. Tête de pose multiple selon l'une des revendications 1 à 8, un dispositif de transmission d'énergie et de données à symétrie de révolution étant disposé entre le support (200) et un boîtier (100) de la tête de pose multiple, dispositif par lequel les entraînements actifs (220, 228) et/ou les capteurs (217) peuvent être alimentés en énergie et par lequel peuvent être transmises les données des capteurs et des données aux capteurs, une première partie de transformateur étant montée à demeure sur le boîtier (100) de la tête de pose multiple et une deuxième partie de transformateur étant montée à demeure sur le support rotatif (200).

10. Tête de pose multiple selon la revendication 9, le dispositif de transmission d'énergie et de données comportant au moins une bague de contact.

11. Tête de pose multiple selon la revendication 9, le dispositif de transmission d'énergie et de données comportant respectivement une paire de transformateurs électriques (410, 420) et une paire de transformateurs capacitifs (415, 425) qui sont disposés respectivement avec symétrie de révolution autour de l'axe de rotation de la tête de pose multiple et qui peuvent transmettre l'énergie et les données sans contact.

12. Tête de pose multiple selon la revendication 11, le transformateur capacitif (415, 425) étant réalisé, pour ce qui est de la première partie de transformateur et de la deuxième partie de transformateur, en tant qu'antenne en forme de plaque dans chaque cas et le transformateur électromagnétique comportant, sur la première partie de transformateur, un corps (410) magnétiquement conducteur réalisé en forme d'anneau, avec une section en forme de U, ouverte en direction du support, ainsi que, sur la deuxième partie de transformateur, un corps (420) magnétiquement conducteur réalisé en forme d'anneau, avec une section sensiblement rectangulaire, lequel est disposé de manière telle dans l'ouverture de la première partie de transformateur que la direction du champ magnétique utilisé pour la transmission d'énergie est sensiblement perpendiculaire à la direction du champ électrique utilisé pour la transmission de données.

13. Tête de pose multiple selon l'une des revendications 9 à 12, respectivement au moins un disque poli (150, 250) étant prévu de manière telle, sur le boîtier (100) et le support (200), que les disques polis (150, 250) sont disposés directement l'un contre l'autre de sorte qu'il est possible d'appliquer aux entraînements actifs (220) du support de l'air comprimé et un vide de générateurs de vide externes.

14. Tête de pose multiple selon l'une des revendications 1 à 13, le support (200) comportant au moins un dispositif de commande (230) pour commander et/ou régler les entraînements actifs (220, 228) resp. les capteurs (217).

15. Tête de pose multiple selon la revendication 14, le dispositif de commande (230) comprenant au moins un processeur numérique de signaux par lequel respectivement un ou plusieurs des entraînements actifs (220, 228) resp. capteurs (217) peuvent être commandés.

16. Tête de pose multiple selon l'une des revendications précédentes, dans laquelle est additionnellement prévu un moteur linéaire (500) qui peut déplacer dans le sens de la pose un outil de préhension (210) se trouvant dans la position de préhension et de pose (A), dans la mesure où le moteur linéaire (500) est en prise avec l'outil de préhension.

17. Tête de pose multiple selon la revendication 16, un élément d'entraînement (212) étant prévu sur chaque outil de préhension, lequel élément d'entraînement peut être mis en prise avec un entraîneur (510) du curseur (520) du moteur linéaire (500).

18. Tête de pose multiple selon l'une des revendications 16 ou 17, comportant additionnellement un moyen de rappel coopérant avec le moteur linéaire (500), par lequel le curseur (520) du moteur linéaire est précontraint au moyen de l'élasticité à l'encontre de la gravité, cette précontrainte étant compensée au moyen d'air comprimé pendant le fonctionnement de la tête de pose.
